# EUROPEAN PATENT APPLICATION

(11) **EP 1 365 450 A1**
(43) Date of publication of application: **26.11.2003**
(21) Application number: 02253673.4
(22) Date of filing: 24.05.2002
(51) Int. Cl.: H01L 23/498, H01L 21/58, H01L 23/433, H01L 23/373

(54) **An improved wire-bonded chip on board package**

(71) Applicant: Ultratera Corporation, Hsin-Chu (TW)
(72) Inventor: Maa, Chong-Ren, Sungshan Chiu, Taipei, Taiwan (TW); Chih, Wan-Kuo, Judung Jen, Hsinchu, Taiwan (TW); Tsai, Ming-Sung, Nuannuan Chiu, Keelung, Taiwan (TW); Shan, Wei-Heng, Hsinchu, Taiwan 300 (CN)
(74) Representative: O'Connell, David Christopher

(57) **Abstract**

A wire-bonded chip on board package has a substrate including a first resin. A solder mask made of a second resin having a thermal expansion coefficient identical to that of the first resin of the substrate is disposed on the top surface of the substrate such that it has a smooth outer surface and some openings to expose the respective areas of the conductive patterns on the top surface. An IC chip with an inactive side thereof tightly attaches to the outer surface of the solder mask. Wire bonds electrically connect the contact pads formed on an active side of the IC chip to the conductive patterns of the top surface. A molding material encapsulates the chip, the wire bonds and the substrate top surface.

## Description

### BACKGROUND OF THE INVENTION

### 1. Field of the Invention

The present invention relates generally to an integrated circuit (IC) chip package, and more particularly to an improved wire-bonded chip on board package.

### 2. Description of the Prior Art

One of the most well known methods used to the mechanical and electrical bonds between the IC chip and the chip carrier (or substrate) is wire bonding. In wire bonding, a plurality of bonding pads are located in a conductive pattern on the top surface of the substrate, with the chip mounted in the center of the pattern of bonding pads and with the top surface of the chip facing away from the top surface of the substrate. Fine wires (which may be aluminum or gold wires) are connected between the contacts on the top surface of the chip and the contacts on the top surface of the substrate.

The substrate typically has a solder mask placed over the metallization patterns for preventing solder from flowing away from the pads along the patterns. Such a solder mask has a coefficient of thermal expansion which is different from that of the substrate. Therefore, a stress will be applied between the resin material and the substrate. As a result, a bending of the substrate is generated. In other words, the surfaces of the substrate are roughened during the solder mask forming procedure. For this reason, the chip can not be firmly mounted in the substrate. Furthermore, it has been hard to reduce the thickness of the package because of more chip attached adhesives being applied to firmly mount the chip in the substrate.

### SUMMARY OF THE INVENTION

It is therefore the primary objective of the present invention to provide an improved wire-bonded chip on board package which has a substrate with smooth surfaces to which an IC chip is tightly attached.

It is another objective of the present invention to provide an improved wire-bonded chip on board package which has a thickness thinner than that of the prior art package.

It is still another objective of the present invention to provide an improved wire-bonded chip on board package having high mechanical reliability and superior heat dissipation characteristics.

These objects can be accomplished by an improved wire-bonded chip on board package comprising a substrate member having planar opposing top and bottom surfaces with conductive patterns. The substrate is made of a material including a first resin. A solder mask is made of a material including a second resin having a thermal expansion coefficient substantially identical to that of the first resin of the substrate. The solder mask is disposed on the top surface of the substrate such that it has a smooth outer surface and a plurality of opening, each opening exposing a respective area of the conductive patterns of the substrate. An IC chip has an active side, an inactive side and a plurality of electrical contact pads on the active side. The chip inactive side is mechanically mounted to the outer surface of the solder mask. Wire bonds electrically connect the electrical contact pads of the IC chip to the conductive patterns of the substrate top surface. A molding material encapsulates the chip, the wire bonds and the substrate top surface.

The objectives, features, and advantages of the present invention will be more readily understood upon a thoughtful deliberation of the following detailed description of a preferred embodiment of the present invention with reference to the accompanying drawings.

### BRIEF DESCRIPTION OF THE DRAWINGS

FIG. 1 is a cross-sectional side view of an improved wire-bonded chip on board package in accordance with an embodiment of the present invention;
FIG.2 is a cross-sectional side view of an improved wire-bonded chip on board package in accordance with another embodiment of the present invention.
FIG.3 illustrates the method of forming a solder mask on a substrate according to the present invention.

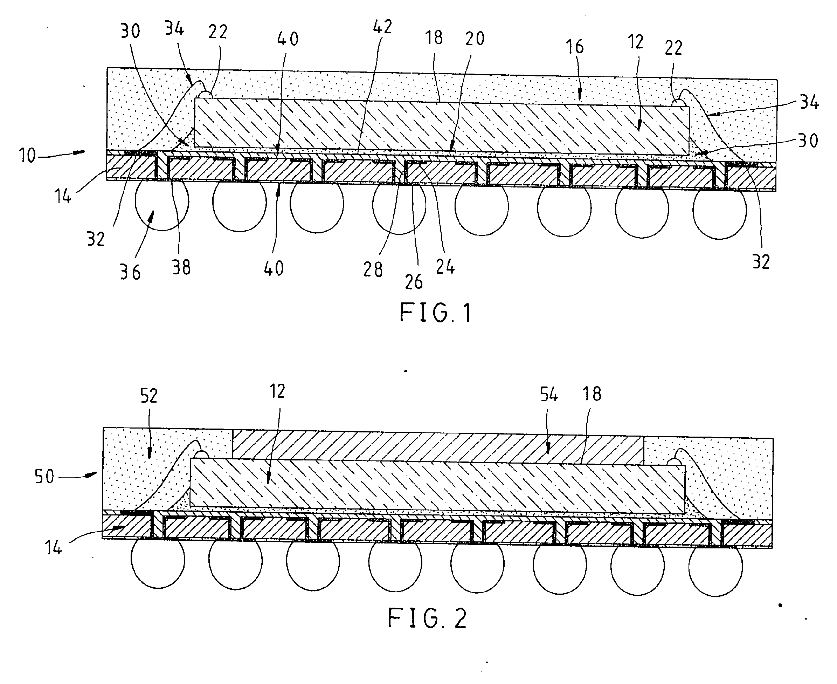

As shown in FIG. 1, there depicts an embodiment of a package 10 according to the present invention. The package 10 includes an IC chip 12, a substrate 14, and a molding material 16 encapsulating the chip and, the substrate.

The IC chip 12 has an active side 18 and an inactive side 20 which are planar and parallel to each other. A plurality of contact pads 22 are disposed on active side 18.

The substrate 14 has conductive patterns 24 and 26 on each surface of the substrate respectively. The substrate' 14 is typically made of a glass-epoxy laminate. The conductive patterns 24 and 26 are electrically connected each other by way of a plurality of conductive vias 28 in the substrate 14. A solder mask 40 is disposed over each surface of the substrate 14. The inactive side 20 of the chip 12 is mounted to the outer surface 42 of the solder mask 40 typically by a layer of epoxy adhesive 30. Each pad 22 is electrically connected to a corresponding contact 32 of the conductive pattern 24 by a bond wire 34. A plurality of solder balls 36 are attached at respective contacts 38 of the conductive pattern 26 on the bottom surface of the substrate 14 to attach to a circuit system.

An epoxy resin is applied on each surface of the substrate such that the conductive vias 28 and the spaces between the conductive patterns 24 and 26 are filled by the epoxy resin, and one layer of an epoxy resin having a predetermined thickness is formed over the conductive patterns of the substrate which serve as a solder mask 40. The method to form the solder mask 40 is detailedly described below.

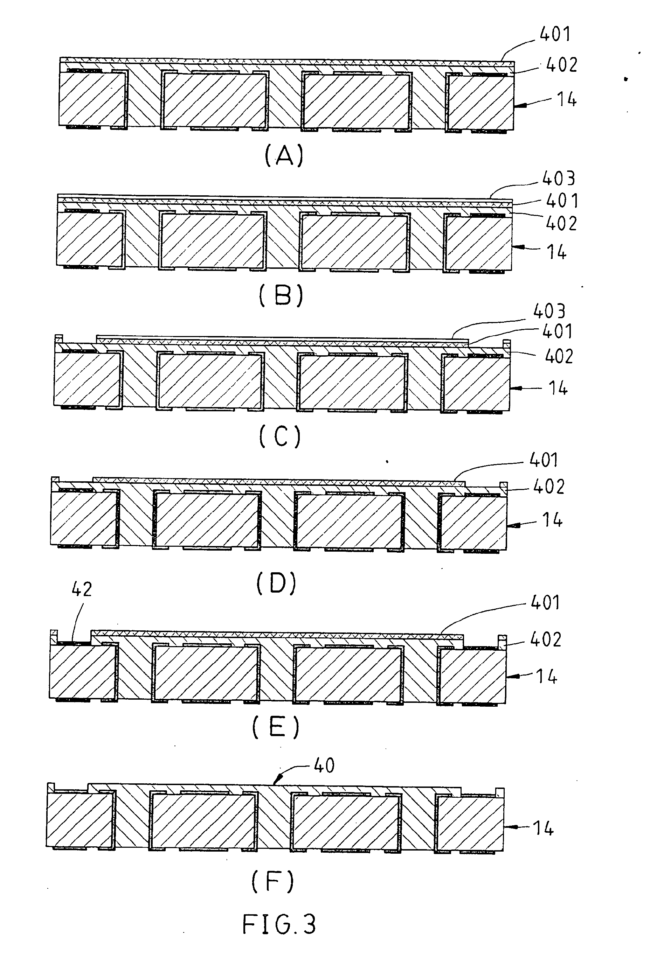

Referring now to FIG.3A, a metal foil 401 (e.g. a copper or aluminum foil) coated with a layer 402 of a partially cured (B-staged) epoxy resin to one side thereof is applied to the top surface of the substrate 14 such that the layer 402 is sandwiched between the substrate 14 and the metal foil 401.

The coated metal foil 401 and the substrate 14 are laminated with a pressure of 10∼40kgw/cm² and a temperature of 140°C∼185°C for 1.5 hours to 3 hours such that the epoxy resin layer 402 is cured and tightly covers the top surface of the substrate 14.

The metal foil 401 surface is then covered with a photo-resist layer 403 (as shown in FIG.3B). The photo-resist is photocured using a mask which allows only the positions to be accessed to remain uncured, and then the uncured areas of the photo-resist and the metal foil thereunder are removed with suitable solvents to expose the underlying epoxy resin layer 402 (as shown in FIG.3C).

Subsequently, the residual (cured) portion of the photo-resist is removed with suitable solvents (as shown in FIG.3D), and then the underlying epoxy resin 402 is removed by a plasma etching method to expose the conductive pattern 42 on the substrate (as shown in FIG.3E).

Lastly, an etching method is applied to remove the residual metal foil 401, leaving the fully cured epoxy resin layer 402 as the solder mask 40 (as shown in FIG.3F)

The solder mask 40 made by the method described above has a smooth outer surface 42 and a thickness between 5µm ∼30µm ( the best thickness is 15 µm).

As shown in FIG.2, there depicts, in cross section, an IC chip package 50 according to a second embodiment of the present invention. In this embodiment, the package 50 has a molding material 52 around the perimeter of the chip 12. The molding material 52 exposes a region of the active side 18 of the chip 12 to allow a thermally and electrically conductive layer 54, for e.g., a copper paste, filled thereon.

As described above, since the solder mask has a smooth outer surface, the inactive side of the chip can be tightly attached thereto. Thus, the reliability of the package according to the present invention will be enhanced. Further, for the same reason, the package needs only an extremely thin layer of epoxy adhesive to mount the chip on the substrate. In other words, the thickness and the producing cost of the package will be significantly reduced. Moreover, because of the thermally and electrical conductive layer filled in the active (upper) side of the IC chip, the package renders more efficient heat dissipation and better electrical performance.

## Claims

1. An improved wire-bonded chip on board package, comprising:
a substrate member made of a material including a first resin, the substrate having planar opposing top and bottom surfaces with conductive patterns;
a solder mask made of a material including a second resin having a thermal expansion coefficient substantially identical to that of the first resin of the substrate disposed on the top surface of the substrate such that it has a smooth outer surface and a plurality of opening, each opening exposing a respective area of the conductive patterns of the substrate;
an IC chip having an active side, an inactive side and a plurality of electrical contact pads on the active side, the chip mechanically mounted to the outer surface of the solder mask with the inactive side thereof;
wire bonds electrically connecting the electrical contact pads of the IC chip to the exposing area of the conductive patterns of the substrate top surface; and
a molding material encapsulating the chip, the wire bonds and the substrate top surface.

2. The flip chip package of claim 1, wherein the molding material exposes a region of the IC chip active side, a thermally and electrically conductive layer is filled in the region.

3. The flip chip package of claim 2, wherein the thermally and electrically conductive layer is a copper paste.

4. The flip chip package of claim 1, wherein the thickness of the solder mask is between 5 µm ∼30 µm.

5. The flip chip package of claim 1, wherein the first resin of the substrate and the second resin of the solder mask are an epoxy resin.

6. The flip chip package of claim 5, wherein the conductive vias are filled by the epoxy resin.

7. The flip chip package of claim 1, wherein the inactive side of the chip is mounted to the outer surface of the solder mask by a layer of epoxy adhesive.

8. The flip chip package of claim 1, wherein the solder mask is disposed on the top surface of the substrate by a method comprising the following steps:
applying to the top surface a metal foil having a partially cured (B-staged) epoxy resin layer on one side of the foil such that the epoxy resin layer is sandwiched between the substrate and the metal foil;
laminating the metal foil and the substrate with a predetermined pressure and temperature for a period of time such that the epoxy resin layer is cured and tightly covers the substrate;
covering a photo-resist layer over the other side of the metal foil;
photocuring positions of the photo-resist layer and removing uncured areas of the photo-resist and the metal foil thereunder to expose the underlying epoxy resin layer;
removing the residual (cured) portion of the photo-resist;
etching away the exposed epoxy resin layer to expose conductive patterns to be soldered;
removing the residual metal foil, and leaving the cured epoxy resin layer as a solder mask.

9. The flip chip package of claim 8, wherein the metal foil is a copper foil.

10. The flip chip package of claim 8, wherein the metal foil is an aluminum foil.

11. The flip chip package of claim 8, wherein the thickness of the solder mask is between 5 µm ∼30 µm.
